# EUROPEAN PATENT APPLICATION

(11) **EP 2 045 028 A1**
(43) Date of publication of application: **08.04.2009**
(21) Application number: 08016787.7
(22) Date of filing: 24.09.2008
(51) Int. Cl.: B22F 1/00, B22F 1/02, B22F 9/00

(54) **Metal nanoparticles, method for producing the same, aqueous dispersion, method for manufacturing printed wiring or electrode, and printed wiring board or device**

(30) Priority: 26.09.2007 JP 2007248816; 11.09.2008 JP 2008233027
(71) Applicant: Fujifilm Corporation, Tokyo 106-8620 (JP)
(72) Inventor: Hirai, Hiroyuki, Ashigarakami-gun Kanagawa (JP)
(74) Representative: Grünecker, Kinkeldey, Stockmair & Schwanhäusser Anwaltssozietät

(57) **Abstract**

The present invention provides metal nanoparticles including silver or silver alloy and an iron compound and having a mean particle diameter of 1 nm to 100 nm.

## Description

### BACKGROUND OF THE INVENTION

### Field of the Invention

The present invention relates to environmentally friendly metal nanoparticles from which a fine wiring pattern having low impedance can be formed without performing firing at high temperature; a method for producing the metal nanoparticles; an aqueous dispersion thereof; a method for manufacturing a printed wiring or electrode using the metal nanoparticles; and a printed wiring board or device formed from the metal nanoparticles.

### Description of the Related Art

Some patent literatures disclose a dispersion of metal nanoparticles with a mean particle diameter of 100 nm or less, and a production method of the dispersion. One patent literature discloses a colloidal dispersion of metal nanoparticles with a mean particle diameter of 10 nm or less which are produced by the gas evaporation method, and a production method of the colloidal dispersion (see Japanese Patent Application Laid-Open (JP-A) No. 03-34211).

Another patent literature discloses a colloidal dispersion of metal microparticles with a mean particle diameter of several to several tens nanometers which are produced through a wet process-the liquid-phase reduction method including reduction using an amine compound-and a production method of the colloidal dispersion (see JP-A No. 11-319538). In this literature, the metal microparticles are covered with polymer resin for maintaining the colloidal state.

As has been known, metal nanoparticles with a mean particle diameter of several to several tens nanometers are generally sintered at a considerably lower temperature than the melting point thereof. This phenomenon is thought to occur for the following reason: metal particles with a very small particle diameter have so high a proportion of high-energy metal atoms on their surfaces that surface diffusion of the metal atoms is unnegligibly activated; and such activated surface diffusion stretches the interfaces among metal particles, causing sintering.

Such metal nanoparticles are fused to one another through contacts therebetween, and the thus-aggregated metal nanoparticles cannot be stably dispersed in a dispersion solvent. As one countermeasure against the above, there has been proposed a method of imparting dispersion stability to metal nanoparticles by covering their surfaces with alkylamine or the like (see JP-A No. 2004-256757). However, the metal nanoparticles produced by this method undesirably decrease in conductivity after exposure to high temperature for sintering.

Also, JP-A No. 2005-93380 discloses silver ink formed of a polyol and silver powder with a particle diameter of 0.6 µm or less. This silver ink can be sintered at a lower temperature, but requires further improvement for forming a fine conductive pattern.

Separately, attempts have been made to rapidly form a fine conductive pattern. JP-A No. 2002-299833 discloses a method of forming a gold- or silver-conductive pattern by discharging a dispersion of gold or silver nanoparticles using an inkjet printer or dispenser. The dispersion in this method contains an organic dispersant in a large amount for preventing metal nanoparticles from aggregation and sedimentation. Thus, after coated on the substrate, the dispersion must be heated to 200°C to 300°C to decompose the organic substances, making it difficult to use a substrate with low thermal resistance (e.g., a substrate made of resin). In addition, an organic solvent is mainly used for dispersing metal nanoparticles, which requires additional treatments for protecting the environment; e.g., recovering the organic solvent during heating. Thus, demand has arisen for further improvement and development thereof.

### BRIEF SUMMARY OF THE INVENTION

An object of the present invention is to provide metal nanoparticles from which a low-resistive conductive pattern can be formed on a resin substrate by printing or coating at low temperature of 200°C or lower; a method for producing the metal nanoparticles; and an aqueous dispersion containing the metal nanoparticles.

Another object of the present invention is to provide a method for manufacturing a printed wiring or electrode, which method can environmentally friendly form, on demand, images with an excellent metal luster and, on a substrate, a fine conductive pattern having a minimum line width/interwire distance of about 20 µm/20 µm using an inkjet printer or dispenser.

The present invention provides the following in order to solve the above-described problems.
<1> Metal nanoparticles including an iron compound and any one of silver and silver alloy, wherein the metal nanoparticles have a mean particle diameter of 1 nm to 100 nm.
   Since the metal nanoparticles described in <1> include silver or silver alloy and an iron compound and have a mean particle diameter of 1 nm to 100 nm, a low-resistive conductive pattern can be formed on a resin substrate by printing or coating at low temperature of 200°C or lower.
<2> The metal nanoparticles according to <1> above, wherein the iron atom content of the iron compound is 0.01 atom% to 10 atom% with respect to the silver or silver alloy.
<3> The metal nanoparticles according to any one of <1> and <2> above, wherein a metal constituting the silver alloy together with silver has a standard electrode potential more positive than the standard electrode potential of the following reaction formula: Fe²⁺ = Fe³⁺ + e⁻.
<4> The metal nanoparticles according to any one of <1> to <3> above, wherein the silver or silver alloy is formed through reduction reaction using an iron(II) compound.
<5> A method for producing the metal nanoparticles according to any one of <1> to <4> above including adding an aqueous solution of an iron(II) salt to an aqueous solution of a silver salt or to an aqueous solution of a silver salt and a salt of a metal other than silver for performing oxidation-reduction reaction, and performing a demineralization treatment.
<6> The method according to <5> above, wherein the oxidation-reduction reaction is performed in the presence of an organic acid or a salt thereof.
<7> An aqueous dispersion including the metal nanoparticles according to any one of <1> to <4> above.
   The aqueous dispersion described in <7> above can readily and environmentally friendly provide, on demand, a fine conductive pattern on a resin substrate using an inkjet printer or dispenser, since it includes the metal nanoparticles of the present invention.
   Also, the aqueous dispersion can provide images with an excellent metal luster on plain or coated paper using an inkjet printer or dispenser.
<8> The aqueous dispersion according to <7> above, wherein the aqueous dispersion is an aqueous ink for use in an inkjet printer or dispenser.
<9> The aqueous dispersion according to any one of <7> and <8> above, wherein the aqueous dispersion contains an organic acid or a salt thereof in an amount of 0.01% by mass to 10% by mass based on the total solid content of the aqueous dispersion.
<10> A method for manufacturing a printed wiring or electrode including coating the aqueous dispersion according to any one of <7> to <9> above onto a substrate made of resin, and drying at 200°C or lower.
<11> A method for manufacturing a printed wiring or electrode including coating the aqueous dispersion according to any one of <7> to <9> above onto a substrate made of resin, and irradiating with laser beams.
<12> A printed wiring board or device manufactured by the method according to any one of <10> and <11>.

The present invention can solve the above-described problems, and can provide metal nanoparticles from which a low-resistive conductive pattern can be formed on a resin substrate by printing or coating at low temperature of 200°C or lower; a method for producing the metal nanoparticles; and an aqueous dispersion containing the metal nanoparticles.

Also, the present invention can provide a method for manufacturing a printed wiring or electrode, which method can environmentally friendly form, on demand, images with an excellent metal luster and, on a substrate, a fine conductive pattern having a minimum line width/interwire distance of about 20 µm/20 µm using an inkjet printer or dispenser.

### BRIEF DESCRIPTION OF THE SEVERAL VIEWS OF THE DRAWINGS

FIG. 1 is a transmission electron microscope (TEM) image of an aqueous dispersion containing metal nanoparticles produced in Example 1.

FIG. 2 is a transmission electron microscope (TEM) image of an aqueous dispersion containing metal nanoparticles produced in Example 2.

FIG. 3 is a transmission electron microscope (TEM) image of an aqueous dispersion containing metal nanoparticles produced in Example 6.

### DETAILED DESCRIPTION OF THE INVENTION

### (Metal nanoparticles)

Metal nanoparticles of the present invention include silver or silver alloy and an iron compound.

The silver or silver alloy are preferably formed through reduction reaction using an iron(II) compound.

The shape of each metal nanoparticle is not particularly limited and can be appropriately selected depending on the purpose. The metal nanoparticle may have any shape such as a spherical shape, cubic shape, flat-plate shape, rod shape or wire shape. The mean particle diameter of flat-plate metal nanoparticles is determined based on their thicknesses. The mean particle diameter of rod- or wire-shaped metal nanoparticles is determined based on their minor axis (width) lengths.

The mean particle diameter of the metal nanoparticles is 1 nm to 100 nm, preferably 3 nm to 50 nm. When the mean particle diameter is less than 1 nm, the metal nanoparticles may be too easily fused to one another; whereas when the mean particle diameter is more than 100 nm, the metal nanoparticles undesirably tend to sediment in the dispersion.

The mean particle diameter of the metal nanoparticles can be measured by, for example, transmission electron microscopy (TEM).

A metal constituting the silver alloy together with silver is not particularly limited and can be appropriately selected depending on the purpose. Examples of the metal include gold, palladium, iridium, platinum, ruthenium, copper, nickel, rhodium, osmium, rhenium, cobalt, tungsten, molybdenum, tin and iron. Of these, palladium, iridium, gold and platinum are particularly preferred.

From the viewpoints of increasing conductivity and dispersion stability, the amount of the metal constituting the silver alloy together with silver is preferably 50 atom% or less, more preferably 30 atom% or less with respect to silver. When the amount is more than 50 atom%, the conductivity and dispersion stability may be deteriorated.

The metal constituting the silver alloy together with silver preferably has a standard electrode potential more positive than the standard electrode potential of the reaction formula: Fe²⁺ = Fe³⁺ + e⁻ (0.771V, 25°C). In this case, silver alloy nanoparticles are easily produced. Standard electrode potentials of metals can be referred to, for example, those described in "Kagaku Binran Kaitei 3 Han Kiso Hen II (Manual for Chemistry 3rd edition (revised), Basic II), pp. 473 to 478".

The standard electrode potential of a metal varies with the types of a compound containing the metal and a compound existing therewith, and is appropriately used in consideration of the above.

The iron compound is not particularly limited and can be appropriately selected depending on the purpose. Examples thereof include iron(III) oxide, iron(II) oxide, iron(II) iron(III) oxide, and iron(III)-organic acids derived from below-described organic acids (or salts thereof).

The iron compound may be present inside or may cover silver or silver alloy. In the latter case, silver or silver alloy (core) may be entirely or partially covered with the iron compound.

From the viewpoints of increasing conductivity and dispersion stability, the iron atom content of the iron compound is preferably 0.01 atom% to 10 atom%, more preferably 0.1 atom% to 5 atom% with respect to the silver or silver alloy. When the content is less than 0.01 atom%, the dispersion stability may be deteriorated; whereas when the content is more than 10 atom%, the conductivity may be decreased.

The iron atom content of the iron compound can be measured using, for example, inductively coupled plasma (ICP).

The silver or silver alloy content of the metal nanoparticles is preferably 90% by mass to 99.9% by mass. The iron content of the metal nanoparticles is preferably 10% by mass to 0.01% by mass.

The silver or silver alloy content and the iron content can be measured using, for example, inductively coupled plasma (ICP).

In the present invention, the iron content and the mean particle diameter of the metal nanoparticles can be controlled by appropriately determining, for example, the amounts of a metal salt, an iron(II) salt, and an organic acid (or a salt thereof); and the solvent used and/or the temperature during particle formation in the production method of the metal nanoparticles (described below).

### (Production method of metal nanoparticles)

A method for producing metal nanoparticles of the present invention is a method for producing the present metal nanoparticles. The present method includes adding an aqueous solution of an iron(II) salt to an aqueous solution of a silver salt or to an aqueous solution of a silver salt and a salt of a metal other than silver for performing oxidation-reduction reaction, and performing a demineralization treatment.

The silver salt, the salt of the metal other than silver, and the iron(II) salt are not particularly limited and can be appropriately selected depending on the purpose. For example, there can be used nitrates thereof, chlorides thereof, phosphates thereof, sulfates thereof, tetrafluoroborates thereof, ammine complexes thereof, chloro complexes thereof and organic acid salts thereof. Among them, nitrates thereof, tetrafluoroborates thereof, ammine complexes thereof, chloro complexes thereof and organic acid salts thereof are particularly preferred, since these have high solubility in water.

The oxidation-reduction reaction is preferably carried out in the presence of an organic acid or a salt thereof.

The amount of the organic acid or a salt thereof is not particularly limited and can be appropriately selected depending on the purpose. The organic acid or a salt thereof is preferably used in an amount of 0.01 mol to 5 mol (more preferably 0.05 mol to 4 mol) with respect to 1 mol of the iron(II) salt, since the formed metal nanoparticles are uniform in composition.

The aqueous solutions of the silver salt, the salt of the metal other than silver, and the iron(II) salt may contain a water-miscible organic solvent described below.

In the demineralization treatment, the formed metal nanoparticles are subjected to, for example, ultrafiltration, dialysis or gel filtration.

### (Aqueous dispersion)

An aqueous dispersion of the present invention includes the present metal nanoparticles, and includes an organic acid or a salt thereof, a dispersion medium and, if necessary, other components.

The present metal nanoparticles content of the aqueous dispersion is preferably 0.1% by mass to 99% by mass, more preferably 1% by mass to 95% by mass. When the content is less than 0.1% by mass, the resistivity of the formed conductive pattern becomes high; whereas when the content is more than 99% by mass, metal nanoparticles may be too easily fused to one another.

The organic acid is not particularly limited and can be appropriately selected depending on the purpose. Examples thereof include acetic acid, propionic acid, citric acid, tartaric acid, succinic acid, butyric acid, fumaric acid, lactic acid, oxalic acid, glycolic acid, acrylic acid, ethylenediaminetetraacetic acid, iminodiacetic acid, nitrilotriacetic acid, ethylene glycolbis(aminoethylether)tetraacetic acid, ethylenediaminedipropionic acid, ethylenediaminediacetic acid, diaminopropanol tetraacetic acid, hydroxyethyliminodiacetic acid, nitrilotrimethylenephosphonic acid and bis(2-ethylhexyl)sulfosuccinic acid. These may be used alone or in combination. Particularly, organic carboxylic acids and salts thereof are preferred.

Examples of the organic acid salts include alkali metal-organic acid salts and organic acid-ammonium salts, with organic acid-ammonium salts being particularly preferred.

The aqueous dispersion preferably contains the organic acid or a salt thereof in an amount of 0.01% by mass to 10% by mass, more preferably 0.05% by mass to 5% by mass, based on the total solid content thereof. When the content is less than 0.01% by mass, the dispersion stability may be deteriorated; whereas when the content is more than 10% by mass, the conductivity may be decreased.

The organic acid (or a salt thereof) content can be measured through, for example, thermogravimetry (TG).

The dispersion solvent for forming the present aqueous dispersion is mostly water. Alternatively, the dispersion solvent may be a mixture of water and a water-miscible organic solvent in an amount of 50 vol.% or less.

The organic solvent is preferably alcohol compounds having a boiling point of 120°C to 300°C (more preferably 130°C to 250°C). When such a high-boiling-point alcohol compound is used in combination with water, the nozzle of an inkjet printer or dispenser is prevented from clogging after dried.

The alcohol compound is not particularly limited and can be appropriately selected depending on the purpose. Examples thereof include ethylene glycol, diethylene glycol, triethylene glycol, polyethylene glycol 200, polyethylene glycol 300, glycerin, propylene glycol, dipropylene glycol, 1,3-propanediol, 1,2-butanediol, 1,4-butanediol, 1,5-pentanediol, 1-ethoxy-2-propanol, ethanolamine, diethanolamine, 2-(2-aminoethoxy)ethanol and 2-dimethylaminoisopropanol. These may be used alone or in combination.

Preferably, the present aqueous dispersion contains no inorganic ions such as alkali metal ions, alkaline earth metal ions and halide ions.

The aqueous dispersion has an electrical conductivity of 1 mS/cm or less, more preferably 0.1 mS/cm or less, still more preferably 0.05 mS/cm.

The aqueous dispersion has a viscosity at 20°C of 0.5 mPa·s to 100 mPa·s, more preferalby 1 mPa·s to 50 mPa·s.

If necessary, the present aqueous dispersion may contain various additives such as a surfactant, a hardener (described below), a polymerizable compound, an antioxidant and a viscosity adjuster.

The present aqueous dispersion is used as aqueous ink for an inkjet printer or dispenser.

In image formation using an inkjet printer, the aqueous dispersion is coated on a substrate such as paper, coated paper, polyethylene-laminated paper, or a PET film whose surface is coated with, for example, a hydrophilic polymer.

The aqueous dispersion of the present invention can be preferably used in a method for manufacturing a printed wiring or electrode described below.

### (Method for manufacturing printed wiring or electrode and printed wiring board or device)

In a first embodiment of a method for manufacturing a printed wiring or electrode of the present invention, the aqueous dispersion of the present invention is coated onto a resin substrate, and the coated dispersion is dried at 200°C or lower.

In a second embodiment of a method for manufacturing a printed wiring or electrode of the present invention, the aqueous dispersion of the present invention is coated onto a resin substrate, and the coated dispersion is irradiated with laser beams.

A printed wiring board or device of the present invention is manufactured by the present method for manufacturing a printed wiring or electrode in the first or second embodiment.

Next will be described in detail the printed wiring board or device of the present invention as well as the method for manufacturing a printed wiring or electrode of the present invention.

The substrate on which the aqueous dispersion is coated (substrate used for forming a printed wiring) is not particularly limited and can be appropriately selected depending on the purpose. Examples thereof include those made of, for example, the following materials:
(1) glass such as quartz glass, alkali-free glass, transparent crystallized glass, PYREX (registered trademark) glass and sapphire,
(2) ceramics of Al₂O₃, MgO, BeO, ZrO₂, Y₂O₃, ThO₂, CaO, GGG (gadolinium gallium garnet), etc.,
(3) acrylic resins such as polycarbonate and polymethyl mathacrylate; vinyl chloride resins such as polyvinyl chloride and vinyl chloride copolymers; and thermoplastic resins such as polyarylate, polysulfone, polyethersulfone, polyimide, PET, PEN, fluorine resins, phenoxy resins, polyolefine resins, nylon, styrene resins and ABS resins,
(4) thermosetting resins such as epoxy resins, and
(5) metals.

Among them, a resin substrate is particularly preferred from the viewpoints of flexibility, lightweight property and suitability to production.

As desired, these materials may be used in combination. Using materials appropriately selected from the above depending on the intended application, a flexible or rigid substrate having a shape of film, etc. can be formed.

The substrate may have any shape such as a disc shape, a card shape or a sheet shape. Also, the substrate may have a three-dimensionally laminated structure. Further, the substrate may have fine pores or grooves with aspect ratios of 1 or more in a portion where the printed wiring is formed, and the present aqueous dispersion may be discharged thereinto using an inkjet printer or dispenser.

The substrate is preferably treated to impart hydrophilicity to the surface thereof. Also, a hydrophilic polymer is preferably coated on the substrate surface. Further, a silane or titanium coupling agent is preferably coated on the substrate surface for hydrolysis. Such treatments allow the aqueous dispersion to be readily coated on the substrate.

The above hydrophilication treatment is not particularly limited and can be appropriately selected depending on the purpose. The hydrophilication treatment employs, for example, chemicals, mechanical roughening, corona discharge, flames, UV rays, glow discharge, active plasma or laser beams. Preferably, the surface tension of the substrate surface is adjusted to 30 dyne/cm or more through this hydrophilication treatment.

The hydrophilic polymer which is coated on the substrate surface is not particularly limited and can be appropriately selected depending on the purpose. Examples thereof include gelatin, gelatin derivatives, casein, agar, starch, polyvinyl alcohol, polyacrylic acid copolymers, carboxymethyl cellulose, hydroxyethyl cellulose, polyvinylpyrrolidone and dextran.

The thickness of the hydrophilic polymer layer is preferably 0.001 µm to 100 µm, more preferably 0.01 µm to 20 µm (in a dried state).

Preferably, a hardener is incorporated into the hydrophilic polymer layer to increase its film strength. The hardener is not particularly limited and can be appropriately selected depending on the purpose. Examples thereof include aldehyde compounds such as formaldehyde and glutaraldehyde; ketone compounds such as diacetyl ketone and cyclopentanedione; vinylsulfone compounds such as divinylsulfone; triazine compounds such as 2-hydroxy-4,6-dichloro-1,3,5-triazine; and isocyanate compounds described in, for example, U.S. Pat. No. 3,103,437.

The hydrophilic polymer layer can be formed as follows: the above hydrophilic compound is dissolved or dispersed in an appropriate solvent (e.g., water) to prepare a coating liquid; and using a coating method such as spin coating, dip coating, extrusion coating or bar coating, the thus-prepared coating liquid is coated on a substrate surface which had undergone a hydrophilication treatment. If necessary, an undercoat layer may be provided between the substrate and the hydrophilic polymer layer for improving adhesiveness therebetween.

The method for applying the present aqueous dispersion on the substrate may be any of the above coating techniques or a known printing method.

A conductive pattern can be formed as follows: the aqueous dispersion is patternwise applied on the substrate surface with an inkjet printer or dispenser, and the coated dispersion is dried.

The temperature in drying is preferably 200°C or lower, more preferably 40°C to 150°C. The drying unit employs, for example, an electric furnace, electromagnetic wave (e.g., microwave), infrared light, a hot plate, laser beams, electron beams, ion beams or heat rays. Preferably, the unit employs laser beams, electron beams, ion beams or heat rays, since they can finely and locally heat the formed pattern. Most preferably, the unit employs laser beams, since a laser device is relatively small and can easily apply energy rays.

Laser irradiation increases the density and electrical conductivity of the printed pattern and thus, a laser device is preferably used for formation of a printed wiring or electrode. The laser beams used may have any wavelengths falling within the regions of ultraviolet light, visible light and infrared light.

Typical examples of the laser include semiconductor lasers using, for example, AlGaAs, InGaAsP or GaN; Nd:YAG lasers; excimer lasers using, for example, ArF, KrF or XeCl; dye lasers; solid-state lasers such as ruby lasers; gaseous lasers using, for example, He-Ne, He-Xe, He-Cd, CO₂ or Ar; and free electron lasers. In addition, there may be employed surface emitting semiconductor lasers, and multimode arrays in which surface emitting semiconductor lasers are arranged one-or two-dimensionally. Laser beams emitted from the above lasers may be high-order harmonics such as second- or third-order harmonics, and may be applied continuously or in a pulsed manner at a plurality of times. Also, the irradiation energy is preferably determined so that metal nanoparticles are not substantially ablated but fused to one another.
- Application -

The present method for manufacturing a printed wiring or electrode is widely applied to, for example, formation of transparent conductive films and multilayered substrates such as IC substrates, formation of wiring circuits on printed wiring boards, formation of fine circuit patterns or fine through holes in multilayered wiring boards such as build-up wiring boards, plastic wiring boards, printed wiring boards and ceramic wiring boards, and formation of various devices including a substrate.

### Examples

The present invention will next be described by way of examples, which should not be construed as limiting the present invention thereto.

In the below Examples and Comparative Examples, "the mean particle diameter of metal nanoparticles", "the iron or silver content of metal nanoparticles, and the iron content of the iron compound", "the viscosity of the aqueous dispersion", and "the resistivity of patterned portions" are measured as follows.

### <Mean particle diameter of metal nanoparticles>

The mean particle diameter of metal nanoparticles was measured through observation with a transmission electron microscope (TEM) (product of JASCO Corporation, JEM-2000FX).

### <The iron or silver content of metal nanoparticles and the iron content of iron compound>

The iron or silver content of metal nanoparticles was measured using inductively coupled plasma (ICP) with an ICPS-1000IV (product of Shimadzu Corporation).

### <Viscosity of aqueous dispersion>

The viscosity of aqueous dispersions was measured at 25°C with a viscometer (product of CBC materials, VISCOMATE VM-1G).

### <Resistivity of irradiated portions (patterned portions)>

The resistivity of irradiated portions (patterned portions) was determined by measuring the surface resistivity of the portions using a Loresta-GP MCP-T600 (product of Mitsubishi Chemical Corporation) and reducing the obtained value on the basis of the thickness of the portions.

### (Example 1)

Solution A was prepared by mixing 10% by mass aqueous silver nitrate solution (20 mL), 20% by mass aqueous potassium sodium tartrate tetrahydrate solution (20 mL), water (60 mL) and 1-ethoxy-2-propanol (20 mL). Solution B was prepared by mixing 30% by mass aqueous iron(II) sulfate heptohydrate solution (11 mL), 20% by mass aqueous potassium sodium tartrate tetrahydrate solution (20 mL), water (60 mL) and 1-ethoxy-2-propanol (20 mL).

Solution B was added to Solution A under stirring. The formed precipitates were recovered through ultrafiltration, and the thus-recovered precipitates were dispersed in 15 vol. % aqueous 1-ethoxy-2-propanol solution.

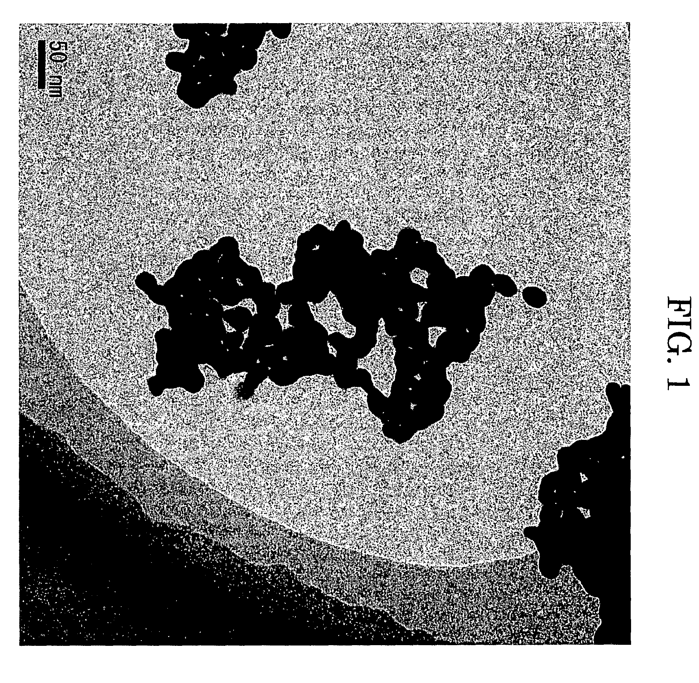

The formed silver nanoparticles were found to have a mean particle diameter of 20 nm (see FIG. 1).

The silver content of the aqueous dispersion was found to be 21.6% by mass, and the iron content 0.09% by mass. Note that the relative iron atom amount with respect to silver was found to be 0.8 atom%.

The viscosity of the aqueous dispersion was found to be 5.2 mPa·s (25°C).

The aqueous dispersion was analyzed through XRD using RINT2500 (product of Rigaku Denki Co.), and the diffraction pattern of silver was observed.

Through FT-IR spectroscopy using a product of JASCO Corporation, the nanoparticles were found to have tartaric acid.

The dried aqueous dispersion was analyzed through thermogravimetry (TG) using a product of Rigaku Denki Co., indicating that it was reduced in mass by 1.8% after heating to 550°C.

A commercially available biaxially stretched, heat set polyethylene terephthalate (PET) substrate (thickness: 300 µm) was corona-charged at 8 W/m²·min. Separately, an undercoat layer-composition was prepared by adding hexamethylene-1,6-bis(ethyleneurea) in an amount of 0.5% by mass to copolymer latex formed of butyl acrylate (40% by mass), styrene (20% by mass) and glycidyl acrylate (40% by mass). The thus-prepared composition was coated on the charged substrate to form an undercoat layer with a thickness of 0.8 µm (in a dried state).

The surface of the undercoat layer was corona-charged at 8 W/m²·min, and then hydroxyethyl cellulose was coated on the charged surface to form a hydrophilic polymer layer with a thickness of 0.2 µm (in a dried state).

Subsequently, the aqueous dispersion was applied patternwise onto the hydrophilic polymer layer with a dispenser, followed by drying in an electric oven at 60°C for 30 min. The resistivity of the patterned portions was found to be 18.2 µΩ·cm. After the patterned portions were irradiated with semiconductor laser beams (809 nm) at 50 mJ/cm², the resistivity of the irradiated portions (patterned portions) was found to be 7.8 µΩ·cm. The above data indicate that the aqueous dispersion of the present invention can provide a low-resistive conductive pattern in a simple manner.

### (Example 2)

Solution A was prepared by mixing 10% by mass aqueous silver nitrate solution (20 mL), 10% by mass aqueous palladium nitrate solution (3 mL), 20% by mass aqueous potassium sodium tartrate tetrahydrate solution (25 mL), water (60 mL) and 1,3-propanediol (20 mL). Solution B was prepared by mixing 30% by mass aqueous iron(II) sulfate heptohydrate solution (14 mL), 20% by mass aqueous trisodium citrate dihydrate solution (25 mL), water (60 mL) and 1,3-propanediol (20 mL).

Solution B was added to Solution A under stirring. The formed precipitates were recovered through ultrafiltration, and the thus-recovered precipitates were dispersed in 20 vol. % aqueous 1,3-propanediol solution.

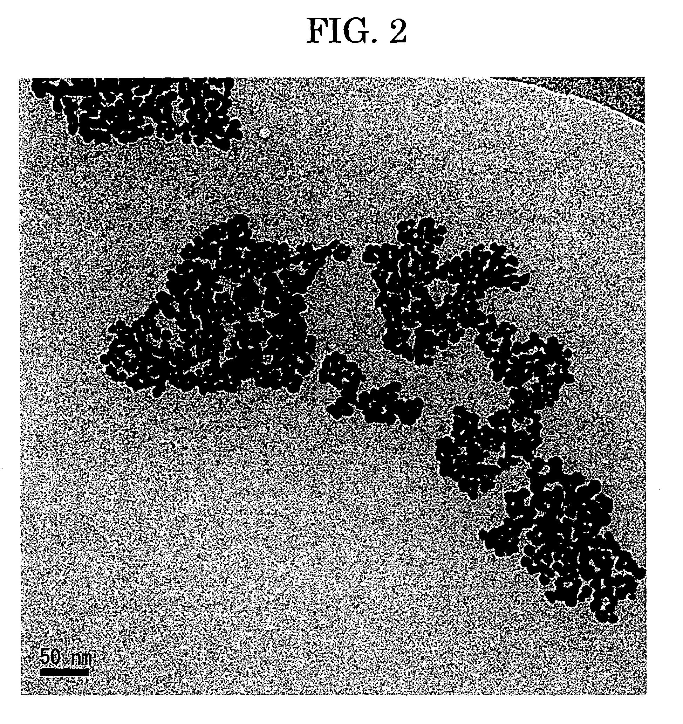

The formed silver alloy nanoparticles were found to have a mean particle diameter of 10 nm (see FIG. 2).

The silver content of the aqueous dispersion was found to be 12.8% by mass, the palladium content 1.3% by mass, and the iron content 0.12% by mass. Note that the relative palladium atom amount with respect to silver was found to be 10.3 atom%, and the relative iron atom amount with respect to silver 1.8 atom%.

The viscosity of the aqueous dispersion was found to be 5.0 mPa·s (25°C).

The aqueous dispersion was analyzed through XRD, and the diffraction pattern of silver-palladium alloy was observed.

The dried aqueous dispersion was analyzed through thermogravimetry (TG), indicating that it was reduced in mass by 2.1% after heating to 550°C.

Similar to Example 1, a PET substrate was provided with a hydrophilic polymer layer. The aqueous dispersion was applied patternwise onto the hydrophilic polymer layer with a dispenser, followed by drying in an electric oven at 60°C for 30 min. The resistivity of the patterned portions was found to be 95.8 µΩ·cm. After the patterned portions were irradiated with semiconductor laser beams (809 nm) at 50 mJ/cm², the resistivity of the irradiated portions (patterned portions) was found to be 19.5 µΩ·cm. The above data indicate that the aqueous dispersion of the present invention can provide a low-resistive conductive pattern in a simple manner.

### (Example 3)

The procedure of Example 2 was repeated, except that palladium nitrate was changed to an equimolar of platinum(II) potassium chloride, to thereby produce an aqueous dispersion containing silver alloy nanoparticles (mean particle diameter: 18 nm) in an amount of 14.8% by mass. The aqueous dispersion contains a trace amount of iron compounds (the relative iron atom amount with respect to silver alloy: 1.1 atom%).

Similar to Example 1, a low-resistive conductive pattern was formed using the aqueous dispersion through drying at 60°C and optional irradiation with laser beams.

### (Example 4)

The procedure of Example 2 was repeated, except that the amount of 10% by mass aqueous silver nitrate solution was changed to 10 mL, and that the amount of the aqueous palladium nitrate solution was changed to 10 mL, to thereby produce an aqueous dispersion containing silver alloy nanoparticles (mean particle diameter: 14 nm).

The silver content of the aqueous dispersion was found to be 7.0% by mass, the palladium content 4.6% by mass, and the iron content 0.8% by mass. Note that the relative iron atom amount with respect to silver alloy was found to be 13.2 atom%.

Similar to Example 2, the aqueous dispersion was applied patternwise onto a substrate, and the patterned portions were dried and irradiated with laser beams. The resistivity of the irradiated portions (patterned portions) was found to be about 100 times that in Example 2.

### (Comparative Example 1)

The procedure of Example 1 was repeated, except that 30% by mass aqueous iron(II) sulfate heptohydrate solution (11 mL) is changed to 10% by mass aqueous sodium tetrahydroborate solution (9 mL) for reducing silver nitrate, to thereby produce silver nanoparticles containing no iron (mean particle diameter: 6 nm). The thus-produced silver nanoparticles could not be dispersed in an aqueous solvent due to a considerable drop in dispersibility.

### (Example 5)

The procedure of Example 1 was repeated, except that the wash liquid used in ultrafiltration was varied in amount, to thereby produce metal nanoparticle samples Nos. 1 to 5. As shown in Table 1, these samples had different relative iron atom amounts with respect to silver. Each sample was dispersed in 15 vol. % aqueous 1-ethoxy-2-propanol solution. Similar to Example 1, the aqueous dispersion was patternwise applied onto a PET substrate, followed by drying at 60°C, and the resistivity of the irradiated portions (patterned portions) was measured. Separately, the dispersion stability of the aqueous dispersion was evaluated thorough observation of its sedimentation status according to the following evaluation criteria. The results are shown in Table 1. Notably, an aqueous dispersion evaluated as "3" has the highest dispersion stability, and an aqueous dispersion evaluated as "1" has the lowest dispersion stability

### [Evaluation criteria]

1: within 10 minutes, almost all metal nanoparticles sedimented
2: within 2 hours, almost all metal nanoparticles sedimented
3: even after 6 hours, metal nanoparticles maintained dispersed

**Table 1**

| Sample No. | 1 | 2 | 3 | 4 | 5 |
|---|---|---|---|---|---|
| Relative iron atom amount (atom%) | 12.1 | 7.2 | 2.1 | 0.8 | 0.05 |
| Mean particle diameter (nm) | 20 | 21 | 20 | 19 | 20 |
| Resistivity (µΩ·cm) | 1,510 | 780 | 122 | 18.2 | 14.7 |
| Dispersion stability | 2 | 3 | 3 | 3 | 1 |

The data shown in Table 1 indicate that the aqueous dispersion having a relative iron amount more than 10 atom% exhibits considerably deteriorated conductivity.

### (Comparative Example 2)

The procedure of Example 1 was repeated, except that 10% by mass aqueous silver nitrate solution (20 mL) was changed to 8% by mass aqueous gold(III) potassium chloride dihydrate solution (20 mL), to thereby prepare a dispersion of gold nanoparticles (mean particle diameter: 50 nm). The thus-produced gold nanoparticles exhibited very poor dispersability in an aqueous solvent, and an aqueous dispersion thereof could not be obtained. Also, through analysis the gold nanoparticles, the relative iron content with respect to the gold atom content was found to be as high as 210 atom%. Furthermore, the dispersion was analyzed through thermogravimetry, indicating that it was reduced in mass by as high as 30.3%.

### (Comparative Example 3)

Through the procedure of Example 1 of JP-A No. 2004-256757, conductive ink containing Ag nanoparticles (mean particle diameter: 12 nm) was prepared. Using a dispenser, the conductive ink was applied patternwise onto a commercially available biaxially stretched, heat set polyethylene terephthalate (PET) substrate (thickness: 300 µm), followed by drying in an electric oven at 60°C for 30 min. The resistivity of patterned portions was found to be considerably high; i.e., 1Ω·cm or higher.

### (Example 6)

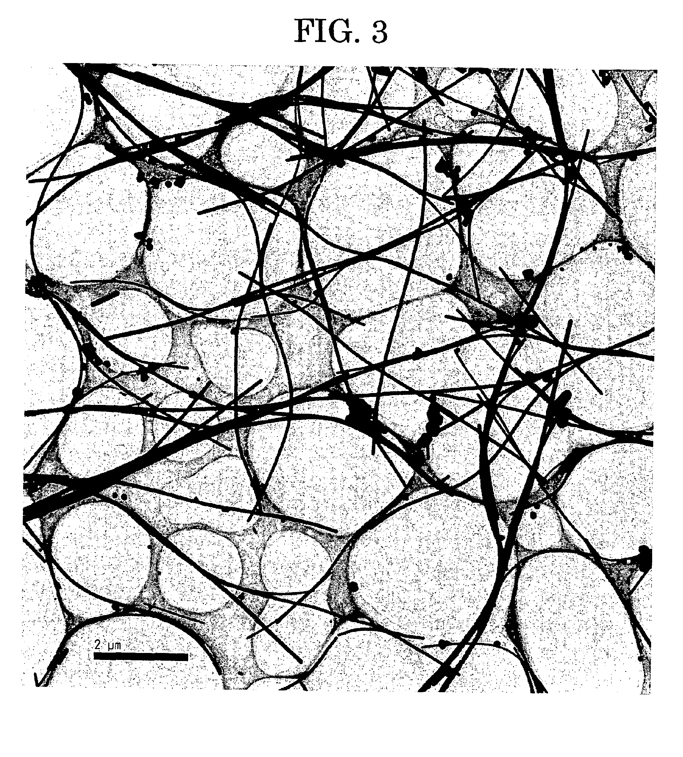

Ethylene glycol (40 mL) was added to a three-necked flask, followed by heating to 170°C. Separately, dihydrogen hexachloroplatinate(IV) hexahydrate (0.52 mg) was dissolved in ethylene glycol (10 mL), and the solution was added to the three-necked flask. Subsequently, an ethylene glycol solution (40 mL) of polyvinylpyrrolidone (PVP) (K-30) (0.45 g) and silver nitrate (0.34 g) was added to the flask at 2 mL/min. The mixture was heated at 170°C for 30 min, and then cooled to room temperature. Under stirring, to the resultant mixture were added an ethylene glycol solution (20 mL) of silver nitrate (0.15 g) and a solution prepared by dissolving potassium sodium tartrate tetrahydrate (0.29 g) and iron(II) sulfate heptohydrate (0.28 g) in water (10 mL). After the mixture was stirred for 5 min, water was added thereto, followed by centrifugation. The resultant product was purified until the conductivity reached 50 µS/cm or lower. Finally, the product was dispersed in 20 vol.% aqueous ethylene glycol solution. The thus-obtained silver nanoparticles were found to have a mean particle diameter (based on minor axis lengths) of 50 nm. Also, each of the silver nanoparticles was found to have a wire shape having a length of several micrometers (see FIG. 3).

The iron content of the aqueous dispersion of silver nanoparticles was found to be 0.06% by mass, and the silver content 28.6% by mass. The relative iron atom amount with respect to silver was found to be 0.4 atom%. Also, the aqueous dispersion was analyzed through thermogravimetry (TG), indicating that it was reduced in mass by 2.8% after heating to 550°C.

Similar to Example 1, a low-resistive conductive pattern could be formed using the aqueous dispersion through drying at 60°C and optional irradiation with laser beams.

The present metal nanoparticles and the present aqueous dispersion containing the metal nanoparticles can form a low-resistive conductive pattern on a resin substrate by printing or coating at low temperature of 200°C or lower, and can form a fine wiring pattern having low impedance without performing firing at high temperature.

The present method for manufacturing a printed wiring or electrode is widely applied to, for example, formation of transparent conductive films and multilayered substrates such as IC substrates, formation of wiring circuits on printed wiring boards, formation of fine wiring patterns or fine through holes in multilayered wiring boards such as build-up wiring boards, plastic wiring boards, printed wiring boards and ceramic wiring boards, and formation of various devices including a substrate.

## Claims

1. Metal nanoparticles comprising:
an iron compound and any one of silver and silver alloy,
wherein the metal nanoparticles have a mean particle diameter of 1 nm to 100 nm.

2. The metal nanoparticles according to claim 1, wherein the iron atom content of the iron compound is 0.01 atom% to 10 atom% with respect to the silver or silver alloy.

3. The metal nanoparticles according to any one of claims 1 and 2, wherein a metal constituting the silver alloy together with silver has a standard electrode potential more positive than the standard electrode potential of the following reaction formula: Fe²⁺ = Fe³⁺ + e⁻.

4. The metal nanoparticles according to any one of claims 1 to 3, wherein the silver or silver alloy is formed through reduction reaction using an iron(II) compound.

5. A method for producing the metal nanoparticles according to any one of claims 1 to 4 comprising:
adding an aqueous solution of an iron(II) salt to an aqueous solution of a silver salt or to an aqueous solution of a silver salt and a salt of a metal other than silver for performing oxidation-reduction reaction, and
performing a demineralization treatment.

6. The method according to claim 5, wherein the oxidation-reduction reaction is performed in the presence of an organic acid or a salt thereof.

7. An aqueous dispersion comprising:
the metal nanoparticles according to any one of claims 1 to 4.

8. The aqueous dispersion according to claim 7, wherein the aqueous dispersion is an aqueous ink for use in an inkjet printer or dispenser.

9. The aqueous dispersion according to any one of claims 7 and 8, wherein the aqueous dispersion contains an organic acid or a salt thereof in an amount of 0.01% by mass to 10% by mass based on the total solid content of the aqueous dispersion.

10. A method for manufacturing a printed wiring or electrode comprising:
coating the aqueous dispersion according to any one of claims 7 to 9 onto a substrate made of resin, and
drying at 200°C or lower.

11. A method for manufacturing a printed wiring or electrode comprising:
coating the aqueous dispersion according to any one of claims 7 to 9 onto a substrate made of resin, and
irradiating with laser beams.

12. A printed wiring board or device manufactured by the method according to any one of claims 10 and 11.
